Europäisches Patentamt

European Patent Office

Office européen des brevets

(19)

(11) Numéro de publication: **0 035 740**
**B1**

(12) # FASCICULE DE BREVET EUROPEEN

(45) Date de publication du fascicule du brevet:
07.03.84

(51) Int. Cl.³: **G 04 G 1/00, H 03 K 17/96**

(21) Numéro de dépôt: **81101528.8**

(22) Date de dépôt: **04.03.81**

(54) **Capteur capacitif pour pièce d'horlogerie et procédé de fabrication dudit capteur.**

(30) Priorité: **07.03.80 CH 1796/80**

(43) Date de publication de la demande:
**16.09.81 Bulletin 81/37**

(45) Mention de la délivrance du brevet:
**07.03.84 Bulletin 84/10**

(84) Etats contractants désignés:
**DE FR GB**

(56) Documents cités:
**DE - A - 2 806 112**
**FR - A - 2 281 617**
**FR - A - 2 331 831**
**GB - A - 2 009 976**
**GB - A - 2 027 209**
**US - A - 3 937 049**
**US - A - 4 056 699**
**US - A - 4 136 291**
**US - A - 4 161 766**

**PATENTS ABSTRACTS OF JAPAN, vol. 2, no. 1, 5 janvier 1978, page 9498E77**

(73) Titulaire: **SOCIETE SUISSE POUR L'INDUSTRIE HORLOGERE MANAGEMENT SERVICES S.A., Rue Stämpfli 96, CH-2500 Bienne (CH)**

(72) Inventeur: **Jaccard, Pierre-Ernest, Chemin Ritter 15, CH-2502 Bienne (CH)**

(74) Mandataire: **Coutts, William Robert et al, SSIH Management Services S.A. Patent Service Rue Stämpfli 96, CH-2500 Bienne (CH)**

Il est rappelé que: Dans un délai de neuf mois à compter de la date de publication de la mention de la délivrance du brevet européen toute personne peut faire opposition au brevet européen délivré, auprès de l'Office européen des brevets. L'opposition doit être formée par écrit et motivée. Elle n'est réputée formée qu'après paiement de la taxe d'opposition (Art. 99(1) Convention sur le brevet européen).

ACTORUM AG

Capteur capacitif pour pièce d'horlogerie et procédé de fabrication dudit capteur

La présente invention concerne un capteur capacitif pour contrôler manuellement la sélection et la correction de fonctions d'une pièce d'horlogerie comportant un substrat électriquement isolant, une première métallisation présentant au moins deux électrodes déposées sur la face supérieure du substrat et aptes à révéler, par l'intermédiaire de moyens électroniques, la transition du doigt sur le capteur pour afficher un symbole recherché, notamment un chiffre, une lettre ou un signe particulier, un diélectrique surmontant lesdites électrodes et une seconde métallisation déposée sur la face inférieure du substrat.

Des capteurs à effet capacitif sont connus de l'état de la technique. Dans certaines applications, ils remplacent avantageusement des boutons-poussoirs mécaniques et on les trouve, par exemple, dans des systèmes de commande d'ascenseur, dans la programmation de machines à coudre et pour commander les diverses fonctions d'une montre électronique, telles que la remise à l'heure ou le choix d'une fonction bien précise.

Un capteur capacitif permettant la sélection et la correction de fonctions d'une montre électronique est décrit dans le document GB-A N° 2009976. Ce capteur est composé de deux électrodes transparentes déposées sur le verre de la montre en dessus des chiffres indiquant 3 et 9 h. Les électrodes sont surmontées d'un diélectrique et sont reliées par des conducteurs électriques à un circuit électronique situé à l'intérieur de la montre. Cependant, la construction proposée ne permet pas un montage compact du capteur et d'atteindre ainsi le but souhaité qui est d'offrir un moyen de sélection et de correction de fonctions par simple transition du doigt sur ledit capteur.

Dans le cas de l'utilisation d'un tel capteur en horlogerie, on comprendra l'intérêt qu'il présente sur un poussoir mécanique qui doit traverser le boîtier pour être accessible de l'extérieur et qui, de ce fait, amène des problèmes d'étanchéité et de pollution entraînant une augmentation des coûts de fabrication et une diminution de la fiabilité du système de commande. Il faut mentionner aussi que l'encombrement d'un capteur capacitif peut être réduit à des dimensions nettement inférieures à celles d'un poussoir mécanique traditionnel.

Dans la demande de brevet EP-A1 N° 0031077 (état de la technique selon l'article 54(3) CBE), on propose un dispositif interactif d'entrée de données pour pièce d'horlogerie comportant un capteur capacitif formé par la juxtaposition de N électrodes délivrant à leur sortie au moins $N-1$ informations codées représentatives de la position du doigt sur le capteur, caractérisé par le fait qu'il comprend des moyens pour générer des signaux représentatifs des données qu'on cherche à sélectionner ou à modifier, des moyens pour afficher ledit symbole sur un affichage composite et des moyens pour détecter le sens et la vitesse du doigt sur le capteur. Si la demande citée décrit en détail l'arrangement électronique d'un tel dispositif, elle ne dit rien sur la réalisation pratique des touches captrices et sur la façon de les incorporer dans la pièce d'horlogerie.

C'est le but de la présente invention de proposer une construction originale comportant la juxtaposition d'au moins deux électrodes, construction qui satisfasse au bon fonctionnement du dispositif interactif d'entrée de données de la demande citée.

C'est un autre but de l'invention de proposer un dispositif compact facile à produire en grandes séries, de dimensions réduites, qui incorpore non seulement les touches capacitives, mais encore le circuit électronique assurant son fonctionnement.

C'est encore un autre but de l'invention de réaliser un capteur sensitif d'aspect plaisant et décoratif, étanche et particulièrement résistant aux sollicitations mécaniques, physiques et chimiques que l'on trouve dans l'environnement habituel d'une montre-bracelet.

Ces buts sont atteints grâce aux moyens et au procédé mis en œuvre pour atteindre ces moyens qui apparaissent dans les deux revendications indépendantes de dispositif et de procédé respectivement.

L'invention sera comprise maintenant à la lumière de la description qui suit donnée à titre d'exemple et à l'aide du dessin dans lequel:

la fig. 1 est une vue de dessus de la pièce d'horlogerie dans laquelle apparaissent l'affichage et un capteur statique indépendant dudit affichage;

la fig. 2 est une coupe selon la ligne A-A à travers le capteur de la fig. 1 et à échelle agrandie;

la fig. 3 montre la métallisation du capteur, côté extérieur, de la pièce d'horlogerie;

la fig. 4 montre la métallisation du capteur, côté intérieur, de la pièce d'horlogerie;

la fig. 5 est une coupe partielle à échelle agrandie selon la ligne B-B de la fig. 1 et qui montre comment le capteur est incorporé dans la pièce d'horlogerie.

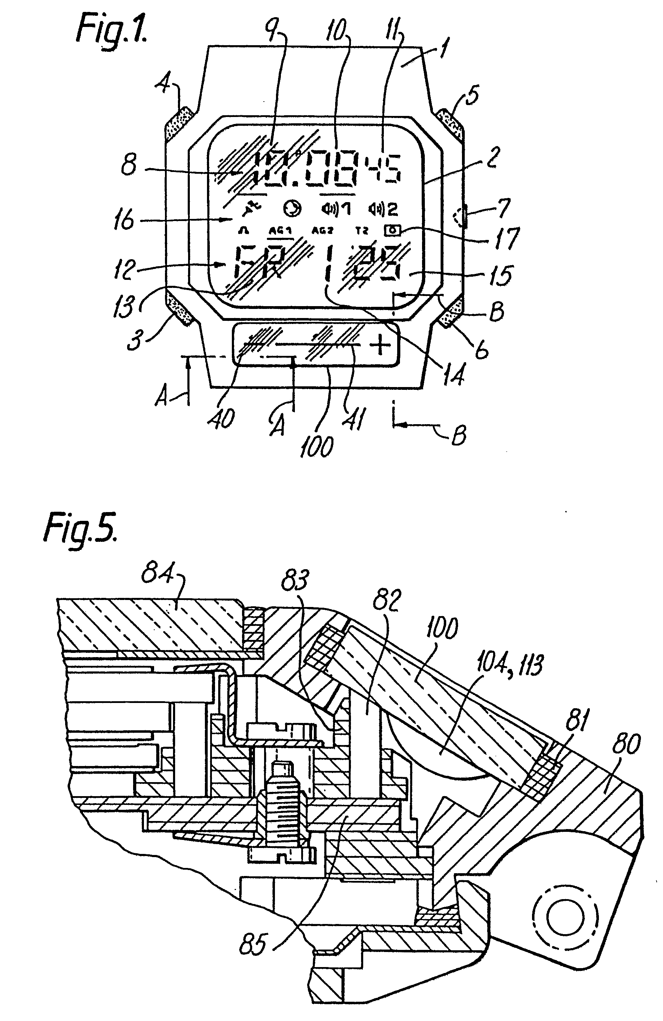

La fig. 1 est une vue de dessus de la pièce d'horlogerie selon l'invention. Elle comporte une boîte 1 dans laquelle sont montés un module électronique dont on aperçoit l'affichage 2, une pluralité 3, 4, 5, 6 et 7 de boutons-poussoirs et un capteur statique 100 objet de la présente invention et qui sera décrit en détail plus loin. L'affichage 2, qui peut être formé d'une cellule à cristal liquide, comprend, outre l'affichage permanent 8 de l'heure normale composée de trois groupes de deux chiffres affichant les heures 9, les minutes 10 et les secondes 11, un affichage auxiliaire 12 qui peut afficher par exemple le jour de la semaine 13, le mois 14 et la date 15. Des signes 16, fixés à demeure et par exemple décalqués sous la glace de la montre, signalent les modes de fonctionnement possibles dans lesquels on peut commuter l'affichage auxiliaire. Par exemple, le signe AG 1 signifie agenda 1 et le signe D la date. L'affichage d'un encadrement 17 signale dans quel mode on se trouve. La demande de brevet déjà citée EP-A1 N° 0031077 décrit en détail comment, au moyen du capteur 100, on met à l'heure l'affichage principal, on sélectionne le mode de fonctionnement et on introduit des données nouvelles dans l'affichage auxiliaire.

La description qui va suivre concerne le capteur statique 100, sa composition et les procédés mis en œuvre pour sa fabrication selon l'invention.

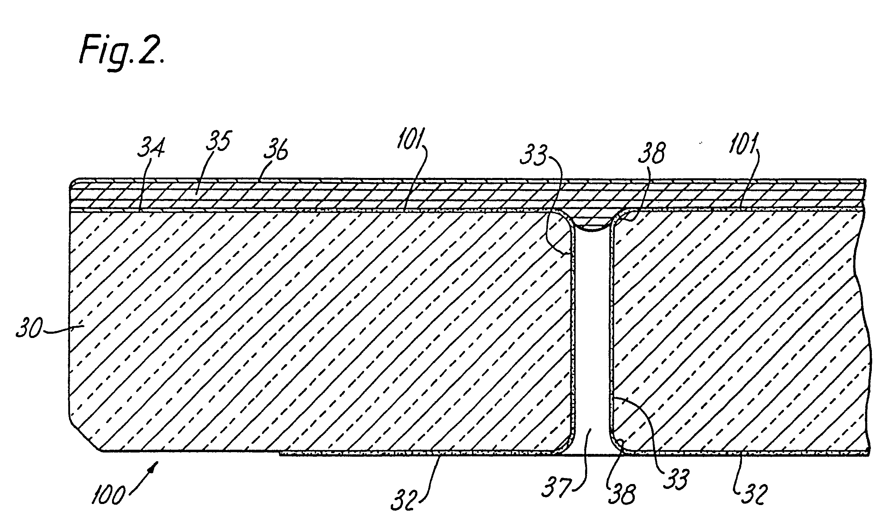

La fig. 2 est une coupe selon la ligne A-A à travers le capteur de la fig. 1 et à échelle agrandie. Le capteur 100 comprend un substrat électriquement isolant 30, une première métallisation 101, une seconde métallisation 32, des moyens de liaisons 33 entre lesdites première et seconde métallisations, une couche de compensation électriquement isolante 34, un diélectrique 35 et une couche décorative 36. La seconde métallisation 32 porte directement les moyens électroniques (non représentés sur la fig. 2) nécessaires au fonctionnement du capteur ainsi que ses bornes de sortie (non visibles en fig. 2).

Les diverses parties entrant dans la composition du capteur vont être décrites maintenant en détail.

Le substrat isolant 30 constitue la base du capteur. Du choix de sa matière et de sa préparation dépendra son aptitude à remplir les performances qu'on attend de lui, c'est-à-dire une forte résistance aux chocs qui peuvent se présenter lors du porter de la montre. C'est le saphir qui, selon l'invention, a été trouvé le plus apte à remplir cette fonction. En plus de sa résistance intrinsèque élevée, le saphir a encore l'avantage de supporter les hautes températures nécessaires à la pose des revêtements dont il sera question plus bas. Du verre par exemple, outre sa grande fragilité, se ramollirait en présence de températures de l'ordre de 800 à 1000°C. Le substrat est obtenu par sciage selon une direction telle que l'axe C de la maille cristalline hexagonale se trouve dans le plan dudit substrat. Il subit ensuite une opération usuelle de mise en forme (par exemple rectangulaire ou trapézoïdale) et de rodage des surfaces. Les trous 37 sont percés au laser. Il faut signaler ici que cette méthode est l'une des seules convenables à un matériau si dur et si épais (de l'ordre de 1 mm). Elle aboutit normalement à un diamètre $d_1$ de trou petit (de l'ordre de 0,1 mm) par rapport à l'épaisseur $d_2$ du substrat, ce qui est avantageux, car il s'agira de l'obturer ensuite au moyen du diélectrique 35, comme cela sera expliqué plus loin. Dans une version préférée de l'invention, le rapport de l'épaisseur $d_2$ au diamètre $d_1$ est arrangé de telle façon que la relation $d_2/d_1 > 4$ soit satisfaite. Le substrat reçoit un traitement thermique de stabilisation, après quoi les trous sont enfin chanfreinés en 38. Les égrisures qui sont apparues à la naissance des trous sont supprimées par un nouveau rodage. Enfin, le substrat est poli fin sur ses deux grandes surfaces. On a trouvé que ce polissage est capital pour la solidité du substrat et contribue, en supprimant les amorces de rupture que pourraient présenter des rayures, à améliorer très nettement sa résistance aux chocs. Pour atteindre la performance souhaitée et selon l'expérience, la rugosité moyenne après polissage ne dépassera pas 0,05 µm (poli optique).

D'autres matériaux peuvent remplacer avec succès le saphir, car ils répondent également aux critères de résistance énoncés plus haut et l'invention s'étend à des substrats comme le spinelle, le rubis, le quartz et la silice amorphe.

Sur le substrat préparé comme indiqué plus haut, il est possible alors de déposer la première métallisation 101, puis la seconde métallisation 32, la métallisation 33 du trou 37 se réalisant en même temps, comme on va le voir.

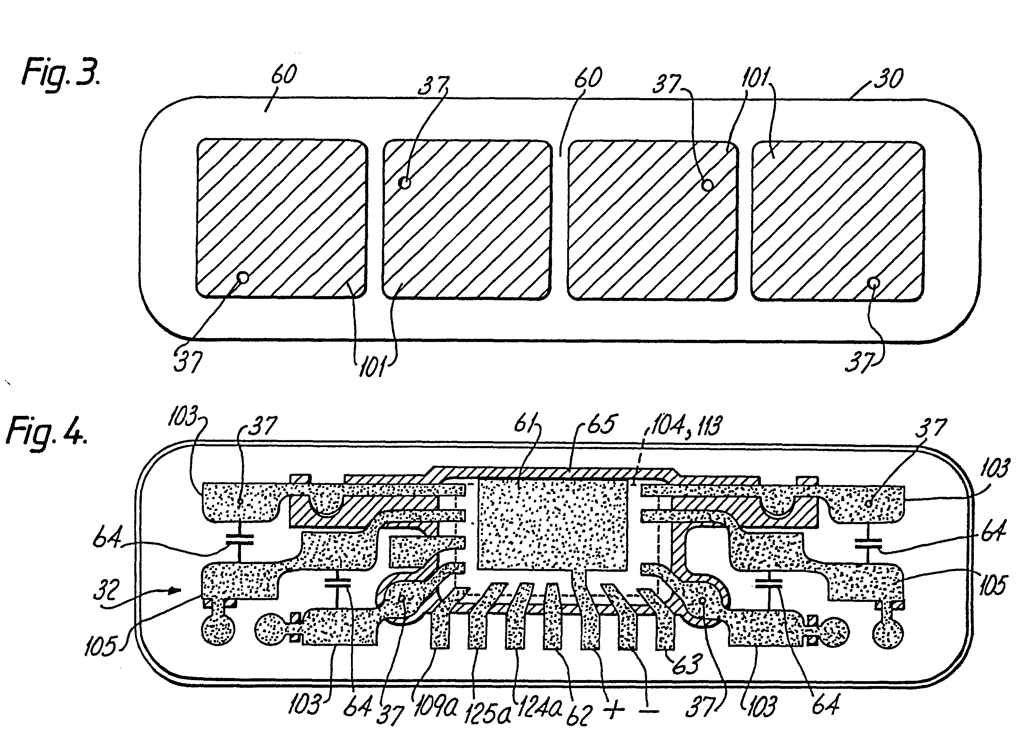

La fig. 3 montre un exemple de géométrie de la première métallisation 101 du substrat, côté extérieur de la pièce d'horlogerie. Sur la face extérieure du substrat 30, on dépose, de préférence par sérigraphie, une pâte conductrice qui peut contenir, par exemple, un mélange de palladium, de platine et d'argent. Quelle que soit la pâte choisie, il est essentiel qu'elle s'adapte bien aux opérations successives de recouvrement qui vont être décrites et surtout qu'elle développe une excellente adhérence sur la surface polie du substrat. La pâte vendue dans le commerce par la firme Electro-Materials Corporation of America (EMCA) sous le numéro de catalogue 7157A satisfait bien à ces exigences. La géométrie de ce dépôt consiste en quatre électrodes de forme carrée 101. Pendant le dépôt de la pâte, on crée une aspiration à travers les trous 37 à partir de la face opposée à celle de la figure, ce qui, additionné à un phénomène naturel de capillarité, contribue à faire pénétrer la pâte à l'intérieur des trous et à former, sur au moins une demi-longueur de ceux-ci, la métallisation 33. Puis la couche épaisse ainsi déposée est cuite au four à une température comprise entre 800 et 1000°C. La constitution de l'écran sérigraphique et la consistance de la pâte sont choisies de telle façon que l'épaisseur de la métallisation après cuisson soit comprise entre 5 et 15 µm.

La fig. 4 montre un exemple de géométrie de la seconde métallisation 32 du substrat, côté intérieur, de la pièce d'horlogerie. Le dépôt a lieu, comme pour les électrodes, par sérigraphie selon les mêmes exigences préférentielles de composition de pâte, de température de cuisson et d'épaisseur de métallisation après cuisson. Pendant l'application de la pâte, on crée la même aspiration à travers les trous 37, mais depuis la face extérieure du substrat cette fois-ci, pour assurer la continuité électrique entre les deux couches métalliques. La configuration de la seconde métallisation telle qu'elle apparaît en fig. 4 fait apparaître divers conducteurs aptes à recevoir les moyens électroniques propres à détecter la position du doigt sur le capteur ainsi que des bornes d'entrée et de sortie dudit capteur. La description reprendra plus loin cet arrangement particulier.

Les première et seconde métallisations ne se limitent pas à un procédé sérigraphique. D'autres moyens connus pourraient être utilisés comme, par exemple, le dépôt de couches minces sous vide, l'essentiel étant, pour la seconde métallisation tout au moins, que l'épaisseur des conducteurs soit compatible avec la connexion par ultrasons de fils d'or ou d'aluminium (bonding), avec la soudure étain-plomb et avec le collage au moyen de colle époxy conductrice.

Si l'on se réfère à nouveau à la fig. 3, on voit qu'il existe des espaces libres 60 entre les électrodes 101. Si l'on veut que la surface finale du capteur soit absolument plane, il est nécessaire de combler ces espaces au moyen d'une couche de compensation 34 qui est visible sur la coupe de la fig. 2. Cette couche électriquement isolante 34 sera appliquée par dépôt sérigraphique, cuite au four à une température comprise entre 800 et 1000°C. Son épaisseur après cuisson devra être la même que celle des électrodes, c'est-à-dire comprise entre 5 et 15 µm. Il faut mentionner ici que l'on pourrait très bien déposer la couche de compensation 34 avant la métallisation 101. Comme pour la couche de métallisation, la couche de compensation devra présenter une excellente adhérence au substrat poli. La pâte de la firme EMCA, déjà citée et portant le numéro de catalogue 2828B, satisfait bien à cette exigence.

La fig. 2 montre encore que la métallisation 101 et la couche de compensation 34 sont surmontées d'un diélectrique 35. Ce dépôt est réalisé par sérigraphie en au moins deux passes d'une pâte isolante. Outre le fait que cette couche doit présenter une constante diélectrique relative $\varepsilon r$ convenable, de valeur comprise entre 8 et 16, elle doit encore assurer une étanchéité parfaite entre la face avant et la face arrière du capteur. La première passe obturera les quatre trous métallisés 37 en même temps qu'elle recouvrira toute la face avant. Après séchage à environ 125°C, elle présente encore des pores microscopiques qui seront recouverts par la deuxième passe dans le but de protéger les électrodes contre l'humidité et d'assurer une obturation parfaite des trous métallisés. Une fois les deux couches appliquées, on cuit la plaquette au four à une température comprise entre 800 et 1000°C. L'épaisseur du diélectrique après cuisson sera de préférence comprise entre 20 et 100 µm. Le diélectrique doit présenter également une bonne adhérence aux couches sur lesquelles il est déposé. Une pâte semblable à celle utilisée pour la couche de compensation répond bien à cette exigence.

A la place du dépôt par sérigraphie du diélectrique, il serait convenable d'utiliser une lame mince de saphir, de verre ou de céramique qui serait appliquée sur le substrat et la métallisation par collage ou autre procédé convenable.

Pour donner un aspect esthétique idoine à la surface apparente du capteur, la fig. 2 montre enfin que la couche diélectrique 35 qui vient d'être décrite est surmontée à son tour par une couche décorative 36. Comme pour les autres couches dont il a été question plus haut, cette couche décorative est déposée par sérigraphie. On choisira de préférence un émail pour porcelaine dont la cuisson se fera à une température comprise entre 770 et 850°C. Ce type d'émail, beaucoup plus résistant que de la peinture à cuire (300°C) ou de l'émail pour verre (< 620°C), est très dur et résiste bien à l'abrasion. Ces qualités obligent à choisir un substrat résistant aux hautes températures (saphir), comme cela a déjà été mentionné plus haut.

La couche décorative peut être appliquée en une seule fois (une seule couleur) ou en plusieurs fois (deux couleurs et plus). Un exemple de décoration en deux couleurs apparaît en fig. 1 où l'on trouve en 40 une couleur blanche et en 41 un motif décoratif noir qui comporte un long trait embrassé par un signe − et par un signe + qui veulent signifier que le groupe de chiffres à corriger diminuera de valeur si le doigt se déplace vers le signe − ou, au contraire, augmentera de valeur si le doigt se déplace vers le signe +.

Il faut mentionner que la couche décorative 36 agit également comme couche diélectrique puisqu'elle est superposée à la couche diélectrique principale 35. Il sera donc important que son épaisseur après cuisson (5 à 20 µm), sa constante diélectrique relative $\varepsilon r$ (comprise entre 6,5 et 13) et ses propriétés d'isolant électrique soient choisies judicieusement pour ne pas détruire l'effet capacitif obtenu par le diélectrique principal.

On dispose donc maintenant d'un capteur statique qui comporte, selon une version préférée de l'invention, quatre électrodes à effet capacitif. Si le porteur de la montre touche avec un doigt la couche décorative 36 dans la zone d'une électrode 101, la capacité du condensateur formé avec la masse du boîtier métallique est modifiée, le doigt faisant partie de l'armature masse et étant séparé de l'électrode 101 par le diélectrique constitué par les couches 35 et 36. Il est donc possible d'utiliser cette variation de capacité pour produire un signal de commande quand la face supérieure du capteur est touchée par le doigt, et de réaliser ainsi un capteur capacitif fondé sur cet effet. Comme cela est décrit en détail dans le brevet CH-B No 607872, ce capteur capacitif est disposé en série avec un condensateur ou capacité d'injection fixe 64 pour former un diviseur capacitif connecté, d'une part, à la masse (armature constituée par le doigt), d'autre part, à une borne 105 d'un générateur de tension alternative délivrant par exemple un signal à 32 kHz. Ainsi, la tension au point de raccordement de l'électrode 101 à une armature 103 du condensateur d'injection 64 est représentative du fait que l'électrode 101 est soumise à une commande ou non.

Selon l'invention, la seconde métallisation 32 sert de conducteurs pour porter directement les moyens électroniques pour détecter la position du doigt sur le capteur et des bornes d'entrée et de sortie dudit capteur. Lesdits moyens électroniques sont décrits en fig. 3 de la demande de brevet déjà citée EP-A1 No 0031077. Le transcodeur 104 et l'ensemble 113 de cette figure sont assemblés en un seul circuit intégré qui est placé comme indiqué sur la fig. 4 de la présente invention. La masse du circuit est collée au moyen d'une colle conductrice sur le champ 61, lui-même relié à la borne d'alimentation +. La sortie du circuit donnant le sens de déplacement du doigt est reliée à la borne 109a et les sorties rapide et lente destinées à influencer l'un ou l'autre groupe d'affichage, selon que le doigt se déplace rapidement ou lentement sur le capteur, sont reliées aux bornes 125a et 124a respectivement. La borne 62 est rendue active à un seul toucher du doigt sur le capteur et permet, par exemple, la mise à zéro des secondes ou l'arrêt d'un signal d'alarme. La borne − est l'entrée négative de l'alimentation et la borne 63 l'entrée du signal à 32 kHz. Comme on l'a déjà vu, les électrodes 101 (figurées en fig. 3) sont reliées électriquement aux conducteurs 103 par les trous métallisés 37. Ces conducteurs 103 sont les mêmes que ceux qui figurent sous la même référence en fig. 3 de la demande de brevet déjà citée EP-A1 No 0031077. Les condensateurs d'injection fixes 64, dont il a été question plus haut ainsi que les conducteurs 103 et 105 sont reliés au circuit intégré comme illustré sur la fig. 4. Les bornes des condensateurs d'injection 64 peuvent être soudées ou collées au moyen de colle époxy conductrice aux conducteurs 103, 105, la métallisation 32 servant à la fois de support et de fixation pour ces condensateurs. Ces condensateurs peuvent être des composants discrets rapportés, mais il serait possible de les intégrer entièrement ou en partie selon des procédés connus directement dans le circuit 104, 113.

Le circuit intégré 104, 113 est relié par bonding aux divers conducteurs qui l'entourent. Une fois cette opération réalisée, on l'encapsule selon des techniques connues. Pour délimiter la zone d'encapsulage et éviter ainsi que de la matière n'atteigne des endroits non désirés, on dépose sur la seconde métallisation 32 un cadre 65 de forte épaisseur (40 à 200 µm) par sérigraphie ou par toute autre technique convenable.

La fig. 5 est une coupe partielle à échelle agrandie selon la ligne B-B de la fig. 1. Elle montre comment le capteur est incorporé dans la pièce d'horlogerie. Dans l'exemple de réalisation, le capteur 100 est chassé dans la carrure 80 à la manière d'une glace de montre au moyen d'une garniture d'étanchéité 81. Sous le capteur, on peut voir le circuit encapsulé 104, 113. Les conducteurs 109a, 124a, 125a, 62, +, −, 63 présentés en fig. 4 sont reliés aux circuits 85 d'utilisation et d'affichage de la montre au moyen d'un connecteur multiple souple 82 du type zebra que le manchon 83 empêche de fléchir.

Dans l'exemple de réalisation illustré par la fig. 5, le capteur 100 est totalement séparé de la glace 84. La présente invention n'est pas limitée à cette disposition. En effet, si la glace est du type saphir (ce qui répondrait donc aux exigences posées par la réalisation du capteur selon l'invention), on pourrait utiliser une seconde zone de cette glace, en dehors de la première qui recouvre normalement l'affichage, pour mettre en œuvre le capteur ici décrit. Quelle que soit la réalisation prévue, on voit que le capteur capacitif est étanche comme une glace habituelle et, comme elle, résiste aux chocs et aux sollicitations mécaniques, physiques et chimiques qui se présentent normalement dans l'environnement d'une montre-bracelet. On a vu aussi que le capteur constitue une unité compacte qui peut être réalisée en grandes séries, contrôlée pour elle-même, puis montée très simplement dans la carrure de la montre.

## Revendications

1. Capteur capacitif pour contrôler manuellement la sélection et la correction de fonctions d'une pièce d'horlogerie comportant un substrat électriquement isolant (30), une première métallisation (101) présentant au moins deux électrodes déposées sur la face supérieure du substrat et aptes à révéler, par l'intermédiaire de moyens électroniques (104, 113, 64), la transition du doigt sur le capteur pour afficher un symbole recherché, notamment un chiffre, une lettre ou un signe particulier, un diélectrique (35) surmontant lesdites électrodes et une seconde métallisation (32) déposée sur la face inférieure du substrat, caractérisé par le fait que le substrat est résistant aux températures de cuisson des couches métalliques et diélectriques déposées sur lui, que le diélectrique (35) est surmonté par au moins une couche décorative (36), que la seconde métallisation (32) sert de conducteurs pour porter directement lesdits moyens électroniques (104, 113, 64), que les électrodes formant la première métallisation (101) sont juxtaposées et que lesdites première et seconde métallisations sont reliées électriquement par des trous métallisés (33) traversant ledit substrat.

2. Capteur capacitif selon la revendication 1, caractérisé par le fait que le substrat comprend une première zone sans métallisation pour recouvrir l'affichage de la pièce d'horlogerie et être utilisée comme glace ordinaire et une seconde zone située en dehors de la première pour former ledit capteur capacitif.

3. Capteur capacitif selon la revendication 1, caractérisé par le fait qu'il constitue une pièce indépendante de la glace de la pièce d'horlogerie.

4. Capteur capacitif selon la revendication 1, caractérisé par le fait que le substrat est constitué par un saphir dont l'axe C de la maille cristalline hexagonale se trouve dans le plan dudit substrat.

5. Capteur capacitif selon la revendication 1, caractérisé par le fait que le substrat est constitué par un spinelle.

6. Capteur capacitif selon la revendication 1, caractérisé par le fait que le substrat est constitué par un rubis.

7. Capteur capacitif selon la revendication 1, caractérisé par le fait que le substrat est constitué par un quartz.

8. Capteur capacitif selon la revendication 1, caractérisé par le fait que le substrat est constitué par une silice amorphe.

9. Capteur capacitif selon la revendication 1, caractérisé par le fait que le rapport de l'épaisseur du substrat $d_2$ au diamètre des trous non métallisés $d_1$ est arrangé pour satisfaire à la relation $d_2/d_1 > 4$.

10. Capteur capacitif selon la revendication 1, caractérisé par le fait qu'une couche de compensation (34) est disposée entre les surfaces (60) exemptes de première métallisation (101) revêtant la face supérieure du substrat et ledit diélectrique (35).

11. Capteur capacitif selon la revendication 1, caractérisé par le fait que le diélectrique a une

constante diélectrique relative εr comprise entre 8 et 16 et que son épaisseur est comprise entre 20 et 100 µm.

12. Capteur capacitif selon la revendication 1, caractérisé par le fait que ladite couche décorative est constituée d'un émail pour porcelaine ayant une constante diélectrique relative εr comprise entre 6,5 et 13 et que son épaisseur est comprise entre 5 et 20 µm.

13. Procédé de fabrication d'un capteur capacitif comme défini dans les revendications 10 à 12, caractérisé par le fait qu'il comprend la succession des opérations suivantes:
— mise en forme géométrique du substrat, perçage des trous et polissage fin des deux faces dudit substrat;
— métallisation des deux faces du substrat par dépôt sérigraphique de la pâte conductrice, métallisation des trous par aspiration et cuisson au four à une température comprise entre 800 et 1000°C;
— pose sérigraphique de la couche de compensation sur la face supérieure du substrat et cuisson au four à une température comprise entre 800 et 1000°C;
— pose sérigraphique du diélectrique en au moins deux passes avec séchage intermédiaire et cuisson au four à une température comprise entre 800 et 1000°C;
— pose sérigraphique de la couche décorative sur le diélectrique et cuisson au four à une température comprise entre 770 et 850°C.

**Patentansprüche**

1. Kapazitiver Fühler zur manuellen Steuerung der Auswahl und der Korrektur von Funktionen eines Zeitgebers, mit einem elektrisch isolierenden Substrat (30), einer ersten Metallisierung (101), die wenigstens zwei Elektroden aufweist, welche auf der oberen Fläche des Substrats aufgebracht sind und die in der Lage sind, mittels elektronischer Anordnungen (104, 113, 64), bei Auflegen eines Fingers auf den Fühler ein gesuchtes Symbol darstellen zu lassen, insbesondere eine Zahl, einen Buchstaben oder ein besonderes Zeichen, wobei ein Dielektrikum (35) die Elektroden bedeckt, und mit einer zweiten Metallisierung (32) auf der unteren Fläche des Substrats, dadurch gekennzeichnet, dass das Substrat widerstandsfähig gegen die Einbrenntemperaturen der auf ihm aufgebrachten metallischen und dielektrischen Schichten ist, dass das Dielektrikum (35) von wenigstens einer Dekorationsschicht (36) bedeckt ist, dass die zweite Metallisierung (32) als Leiter dient, welcher direkt die elektronischen Anordnungen (104, 113, 64) trägt, dass die die erste Metallisierung (101) bildenden Elektroden nebeneinander liegen und dass die erste und die zweite Metallisierung elektrisch miteinander durch metallisierte Öffnungen (33) im Substrat verbunden sind.

2. Kapazitiver Fühler nach Anspruch 1, dadurch gekennzeichnet, dass das Substrat einen ersten Bereich ohne Metallisierung aufweist, die den Anzeigebereich des Zeitgebers überdeckt und als herkömmliche Abdeckscheibe dient und einen zweiten Bereich aufweist, der ausserhalb des ersten liegt, um den kapazitiven Fühler zu bilden.

3. Kapazitiver Fühler nach Anspruch 1, dadurch gekennzeichnet, dass er ein von der Abdeckscheibe des Zeitgebers unabhängiges Bauteil bildet.

4. Kapazitiver Fühler nach Anspruch 1, dadurch gekennzeichnet, dass das Substrat aus einem Saphir besteht, dessen C-Achse des hexagonalen kristallinen Gitters in der Ebene des Substrats liegt.

5. Kapazitiver Fühler nach Anspruch 1, dadurch gekennzeichnet, dass das Substrat aus einem Spinell besteht.

6. Kapazitiver Fühler nach Anspruch 1, dadurch gekennzeichnet, dass das Substrat aus einem Rubin besteht.

7. Kapazitiver Fühler nach Anspruch 1, dadurch gekennzeichnet, dass das Substrat aus einem Quarz besteht.

8. Kapazitiver Fühler nach Anspruch 1, dadurch gekennzeichnet, dass das Substrat aus einem amorphen Silizium besteht.

9. Kapazitiver Fühler nach Anspruch 1, dadurch gekennzeichnet, dass das Verhältnis der Dicke des Substrats $d_2$ zum Durchmesser der nichtmetallisierten Öffnungen $d_1$ derart gewählt ist, dass es die Bedingung $d_2/d_1 > 4$ erfüllt.

10. Kapazitiver Fühler nach Anspruch 1, dadurch gekennzeichnet, dass eine Kompensationsschicht (34) angeordnet ist zwischen den Flächen (60), die frei von der ersten, die obere Fläche des Substrats bedeckenden Metallisierung (101) sind, und dem Dielektrikum (35).

11. Kapazitiver Fühler nach Anspruch 1, dadurch gekennzeichnet, dass das Dielektrikum eine relative Dielektrizitätskonstante εr zwischen 8 und 16 aufweist, und dass seine Dicke zwischen 20 und 100 µm liegt.

12. Kapazitiver Fühler nach Anspruch 1, dadurch gekennzeichnet, dass die Dekorationsschicht aus einer für Porzellan geeigneten Emailschicht besteht mit einer relativen Dielektrizitätskonstanten εr zwischen 6,5 und 13, wobei ihre Dicke zwischen 5 und 20 µm liegt.

13. Verfahren zur Herstellung eines kapazitiven Fühlers gemäss den Ansprüchen 10 bis 12, dadurch gekennzeichnet, dass es die folgende Folge von Verfahrensschritten aufweist:
— geometrische Formgebung des Substrats, Bohrung der Öffnungen und Feinschleifen der beiden Substratflächen;
— Metallisierung der beiden Substratflächen durch Siebdruckaufbringen der leitenden Paste, Metallisierung der Öffnungen durch Ansaugen und Einbrennen im Ofen bei einer Temperatur zwischen 800 und 1000°C;
— Siebdruckaufbringen der Kompensationsschicht auf die obere Fläche des Substrats und Einbrennen im Ofen bei einer Temperatur zwischen 800 und 1000°C;
— Siebdruckaufbringen des Dielektrikums in wenigstens zwei Durchgängen mit dazwischenliegender Trocknung und Einbrennen im Ofen bei einer Temperatur zwischen 800 und 1000°C;
— Siebdruckaufbringen der Dekorationsschicht auf das Dielektrikum und Einbrennen im Ofen bei einer Temperatur zwischen 770 und 850°C.

## Claims

1. A capacitive pick-up for manually controlling the selection and correction of timepiece functions comprising an electrically insulating substrate (30), a first metallization (101) including at least two electrodes deposited on the upper surface of said substrate and adapted to reveal through electronic means (104, 113, 64) the passage of a finger over the pick-up in order to display a desired symbol such as a digit, a letter or special sign, a dielectric (35) over said electrodes and a second metallization (32) déposited on the lower surface of the substrate, characterized in that the substrate is resistant to the baking temperatures of the metallic and dielectric layers deposited thereon, that the dielectric (35) is surmounted by at least one decorative layer (36), that the second metallization (32) serves as conducting means for bearing directly said electronic means (104, 113, 64), that the electrodes forming the first metallization (101) are juxtaposed and that said first and second metallizations are electrically coupled by metallized holes (33) traversing said substrate.

2. A capacitive pick-up according to claim 1, characterized in that the substrate includes a first zone without metallization arranged to cover the timepiece display and serving as an ordinary watch crystal and a second zone situated outside the first zone so as to form the pick-up.

3. A capacitive pick-up according to claim 1, characterized in that it constitutes an element independent of the watch crystal.

4. A capacitive pick-up according to claim 1, characterized in that the substrate is formed from a sapphire of which the C axis of the hexagonal crystal lattice lies in the plane of the substrate.

5. A capacitive pick-up according to claim 1, characterized in that the substrate is formed from a spinel.

6. A capacitive pick-up according to claim 1, characterized in that the substrate is formed from a ruby.

7. A capacitive pick-up according to claim 1, characterized in that the substrate is formed from quartz.

8. A capacitive pick-up according to claim 1, characterized in that the substrate is formed from amorphe silica.

9. A capacitive pick-up according to claim 1, characterized in that the ratio of the thickness of the substrate $d_2$ to the diameter of the holes prior to metallization $d_1$ is chosen so as to satisfy the relationship $d_2/d_1 > 4$.

10. A capacitive pick-up according to claim 1, characterized in that a compensating layer (34) is arranged between the surface portions (60) free of the first metallization (101) of the upper surface of the substrate and said dielectric (35).

11. A capacitive pick-up according to claim 1, characterized in that the dielectric has a relative dielectric constant $\varepsilon r$ between 8 and 16 and that its thickness lies between 20 and 100 µm.

12. A capacitive pick-up according to claim 1, characterized in that the decorative layer is formed by a porcelain enamel having a relative dielectric constant $\varepsilon r$ between 6.5 and 13 and a thickness between 5 and 20 µm.

13. A manufacturing process for a capacitive pick-up as defined in claims 10 to 12, characterized by the following series of operations:

— geometrically forming a substrate, piercing of holes therein and fine polishing of the two surfaces thereof;

— metallization of the two surfaces of the substrate by silk screen deposit of the conducting paste, metallization of the holes by aspiration and oven baking at a temperature between 800 and 1000°C;

— silk screen depositing of the compensation layer onto the upper surface·of the substrate and oven baking at a temperature between 800 and 1000°C;

— silk screen depositing of the dielectric in at least two stages with intermediate drying and oven baking at a temperature between 800 and 1000°C;

— silk screen depositing of the decorative layer onto the dielectric and oven baking at a temperature between 770 and 850°C.

**Fig.1.**

**Fig.5.**

Fig.2.

0 035 740

Fig. 3.

Fig. 4.